# EUROPEAN PATENT APPLICATION

(11) **EP 4 398 291 A1**
(43) Date of publication of application: **10.07.2024**
(21) Application number: 22864341.7
(22) Date of filing: 23.08.2022
(51) Int. Cl.: H01L 23/12, H01L 23/36, H01L 33/62, H01L 33/64, H05K 1/02

(54) **WIRING SUBSTRATE AND ELECTRONIC DEVICE**

(30) Priority: 31.08.2021 JP 2021141686
(71) Applicant: Kyocera Corporation, Kyoto-shi Kyoto 612-8501 (JP)
(72) Inventor: NAKAMOTO, Koutarou, Kyoto-shi, Kyoto 612-8501 (JP)
(74) Representative: Viering, Jentschura & Partner mbB Patent- und Rechtsanwälte
(86) International application number: PCT/JP2022/031717
(87) International publication number: WO 2023/032757

(57) **Abstract**

An object of the present disclosure is to improve connection reliability between a wiring substrate and an electronic component by improving the flatness of a component mounting surface of a heat dissipation member. A wiring substrate includes a wiring conductor extending from a first surface to a second surface of an insulating substrate, a frame-shaped metal layer located on a bottom surface of a recessed portion of the insulating substrate and surrounding a through hole, and a heat dissipation member located in the recessed portion of the insulating substrate so as to close the through hole, bonded to the frame-shaped metal layer by a brazing material, and having a component mounting surface on the through hole side. The frame-shaped metal layer has a projecting portion protruding toward the heat dissipation member, and the projecting portion is located so as to overlap the heat dissipation member in a transparent plan view.

## Description

### TECHNICAL FIELD

The present disclosure relates to a wiring substrate and an electronic device.

### BACKGROUND OF INVENTION

In recent years, various developments have been made with respect to electronic devices including a wiring substrate and an electronic component mounted on the wiring substrate. A wiring substrate described in Patent Document 1 includes an insulating substrate having a through hole, and a heat dissipation member (heat radiator of Patent Document 1) located on the insulating substrate so as to close the through hole. The heat dissipation member is bonded to a peripheral edge portion of the through hole in the insulating substrate by a bonding material. The heat dissipation member has a component mounting surface for mounting an electronic component (electronic element of Patent Document 1) on the through hole side of the insulating substrate.

### CITATION LIST

### PATENT LITERATURE

Patent Document 1: WO2020/045480 A1

### SUMMARY

A wiring substrate according to the present disclosure includes an insulating substrate having a first surface, a second surface located on an opposite side to the first surface, a recessed portion opening to the second surface, and a through hole penetrating from a bottom surface of the recessed portion to the first surface; a wiring conductor extending from the first surface to the second surface; a frame-shaped metal portion located on the bottom surface of the recessed portion and surrounding the through hole; and a heat dissipation member located in the recessed portion and closing the through hole, bonded to the frame-shaped metal portion by a brazing material, and having a component mounting surface on the through hole side, wherein the frame-shaped metal portion includes a projection portion protruding toward the heat dissipation member, and the projection portion is located so as to overlap the heat dissipation member in a transparent plan view.

An electronic device according to the present disclosure includes: the wiring substrate; and an electronic component mounted on the component mounting surface of the heat dissipation member, located in the through hole, and electrically connected to the wiring conductor.

### BRIEF DESCRIPTION OF THE DRAWINGS

FIG. 1 is a schematic perspective view of an electronic device according to a first embodiment, illustrating a state in which a lid is removed.
FIG. 2 is a schematic plan view of the electronic device illustrated in FIG. 1.
FIG. 3 is a schematic bottom view of the electronic device illustrated in FIG. 1.
FIG. 4 is a schematic cross-sectional view of the electronic device illustrated in FIG. 1.
FIG. 5 is a schematic perspective view of a wiring substrate according to the first embodiment as viewed from an insulating frame body side.
FIG. 6 is a schematic perspective view of the wiring substrate illustrated in FIG. 5 as viewed from a second surface side of an insulating substrate.
FIG. 7 is a schematic perspective view of the wiring substrate illustrated in FIG. 5 as viewed from the second surface side of the insulating substrate, illustrating a state in which a heat dissipation member is removed.
FIG. 8 is a schematic bottom view of the wiring substrate illustrated in FIG. 5, illustrating a state in which the heat dissipation member is removed.
FIG. 9 is a schematic cross-sectional view illustrating a state in which the electronic device illustrated in FIG. 1 is mounted on a mother substrate.
FIG. 10 is a schematic cross-sectional view of an electronic device according to a second embodiment.
FIG. 11 is schematic bottom view of the electronic device illustrated in FIG. 10.
FIG. 12 is a schematic perspective view of a wiring substrate according to the second embodiment as viewed from a second surface side of an insulating substrate, illustrating a state in which a heat dissipation member is removed.
FIG. 13 is a schematic bottom view of the wiring substrate illustrated in FIG. 12, illustrating a state in which the heat dissipation member is removed.
FIG. 14 is a schematic perspective view of the wiring substrate according to the second embodiment as viewed from the second surface side of the insulating substrate, illustrating a state in which a plurality of side-surface metal layers are located at intervals in a circumferential direction of an inner peripheral surface of a recessed portion of the insulating substrate.
FIG. 15 is a schematic cross-sectional view illustrating a state in which the electronic device illustrated in FIG. 10 is mounted on a mother substrate.
FIG. 16 is a schematic partial enlarged cross-sectional view illustrating a state in which the electronic device illustrated in FIG. 10 is mounted on the mother substrate.
FIG. 17 is a schematic cross-sectional view taken along a line XVII-XVII in FIG. 19.
FIG. 18 is a schematic cross-sectional view taken along a line XVIII-XVIII in FIG. 19.
FIG. 19 is a schematic bottom view of an electronic device according to a third embodiment.
FIG. 20 is a schematic perspective view of a wiring substrate according to the third embodiment as viewed from a second surface side of an insulating substrate, illustrating a state in which a heat dissipation member is removed.
FIG. 21 is a schematic bottom view of the wiring substrate illustrated in FIG. 20, illustrating a state in which the heat dissipation member is removed.
FIG. 22 is a schematic cross-sectional view illustrating a state in which the electronic device illustrated in FIG. 19 is mounted on a mother substrate.
FIG. 23 is a schematic partial enlarged cross-sectional view illustrating a state in which the electronic device illustrated in FIG. 19 is mounted on the mother substrate.

### DESCRIPTION OF EMBODIMENTS

In a manufacturing process of an electronic device, when bonding a heat dissipation member to a peripheral edge portion of a through hole in an insulating substrate, a bonding material may flow to a component mounting surface side of the heat dissipation member. In such a case, there is a concern that the flatness of the component mounting surface of the heat dissipation member deteriorates.
In a wiring substrate and an electronic device according to the present disclosure, the flatness of the component mounting surface of the heat dissipation member can be improved.

Hereinafter, a wiring substrate and an electronic device according to embodiments will be described below in detail with reference to the drawings. However, each of the figures, which will be referred to below, is a simplified representation of only components necessary for description of the embodiments. Accordingly, the wiring substrate and the electronic device according to the embodiments may be provided with an optional component that is not illustrated in the referenced figures. The dimensions of the components in the drawings may not faithfully represent the actual dimensions of the components, the dimension ratios of the members, or the like. In the present disclosure, the rectangular shape is not limited to a strict rectangular shape, and includes a shape that can be visually recognized as a rectangular shape as a whole even if corner portions are curved, for example. In the drawings of the present disclosure, in addition to hatching applied to cross-sectional portions, dots are applied to a surface of a conductor portion, a surface of an electronic component, a surface of a heat dissipation member, and a surface of a brazing material.

### First Embodiment

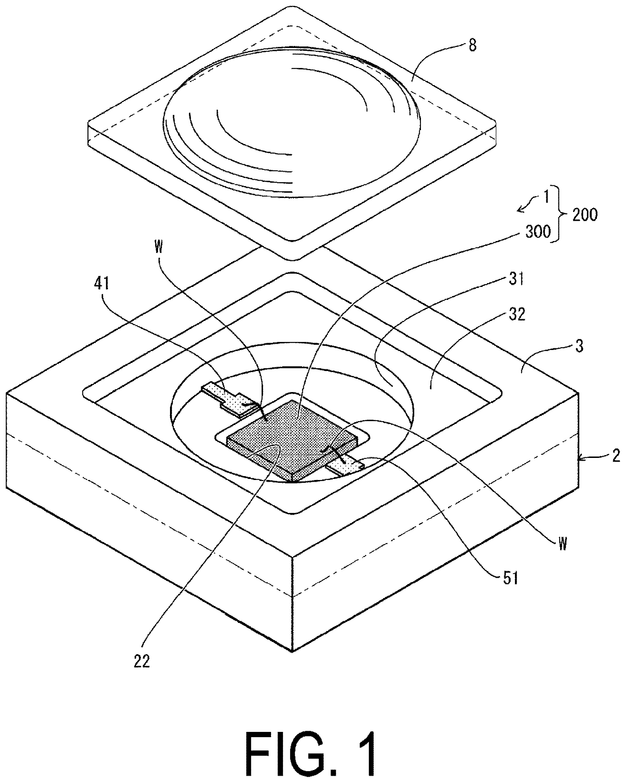

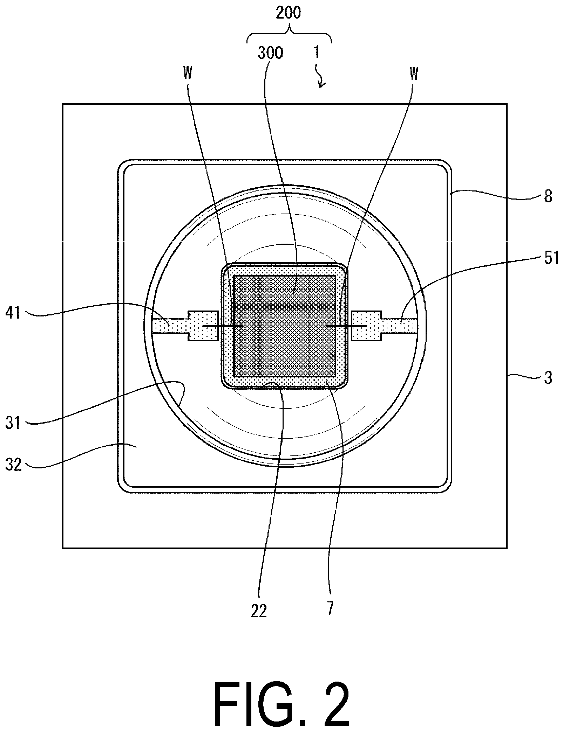

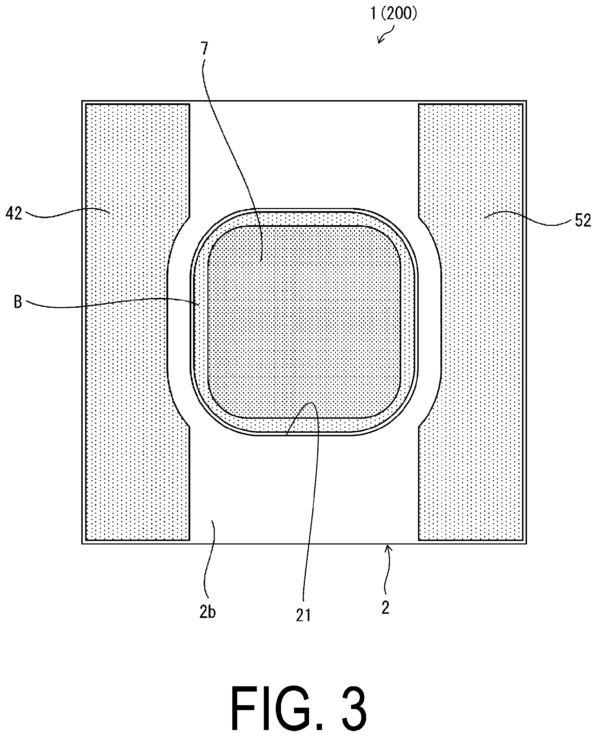

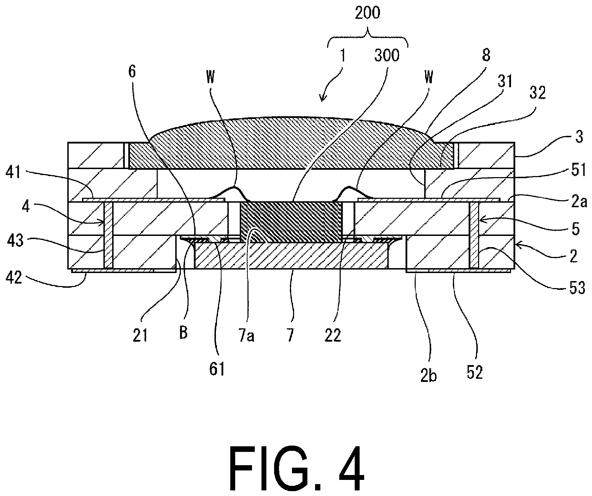

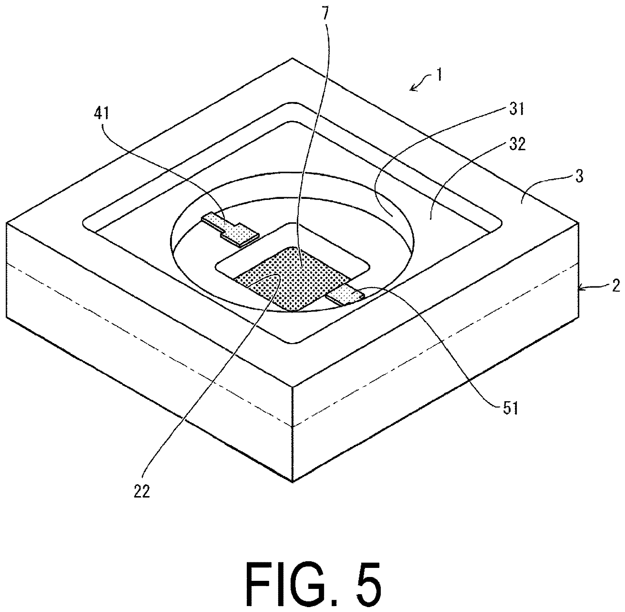

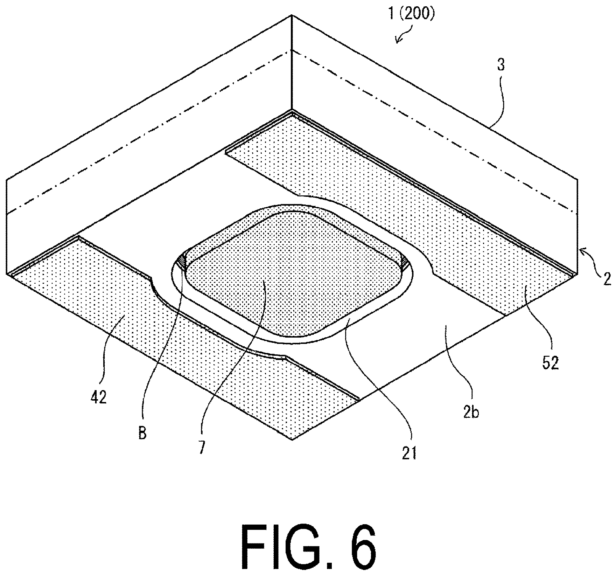

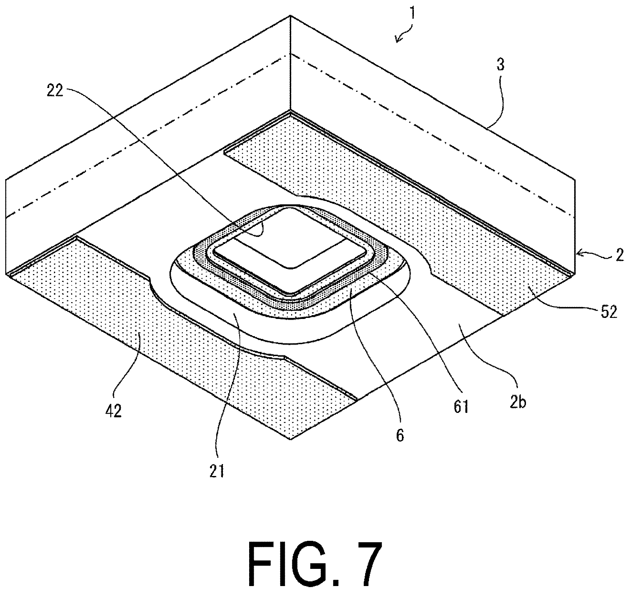

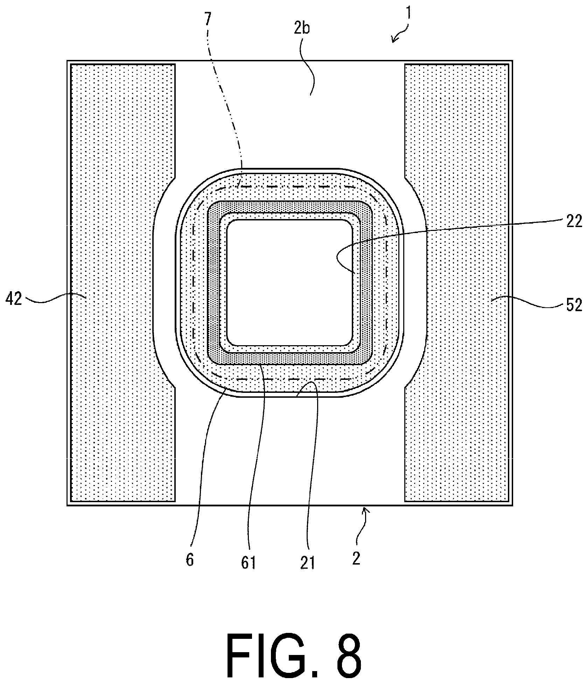

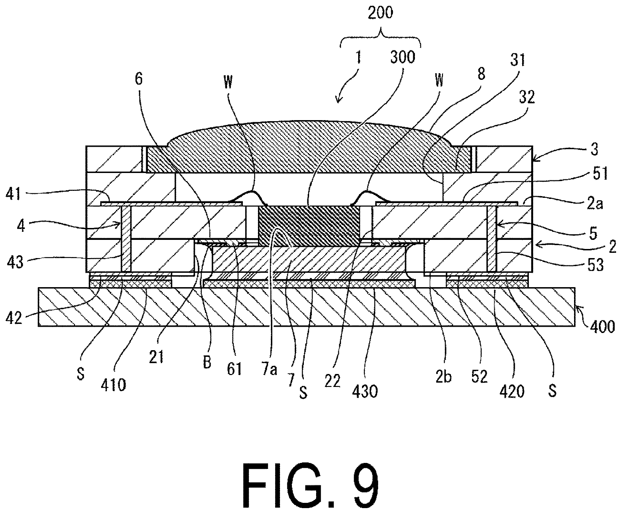

A first embodiment will be described below with reference to FIGs. 1 to 9. FIG. 1 is a schematic perspective view of an electronic device according to a first embodiment, illustrating a state in which a lid is removed. FIG. 2 is a schematic plan view of the electronic device illustrated in FIG. 1. FIG. 3 is a schematic bottom view of the electronic device illustrated in FIG. 1. FIG. 4 is a schematic cross-sectional view of the electronic device illustrated in FIG. 1. FIG. 5 is a schematic perspective view of a wiring substrate according to the first embodiment as viewed from an insulating frame body side. FIG. 6 is a schematic perspective view of the wiring substrate illustrated in FIG. 5 as viewed from a second surface side of an insulating substrate. FIG. 7 is a schematic perspective view of the wiring substrate illustrated in FIG. 5 as viewed from the second surface side of the insulating substrate, illustrating a state in which a heat dissipation member is removed. FIG. 8 is a schematic bottom view of the wiring substrate illustrated in FIG. 5, illustrating a state in which the heat dissipation member is removed. FIG. 9 is a schematic cross-sectional view illustrating a state in which the electronic device illustrated in FIG. 1 is mounted on a mother substrate.

As illustrated in FIGs. 1 to 4, an electronic device 200 according to the first embodiment includes a wiring substrate 1 according to the first embodiment and an electronic component 300 mounted on the wiring substrate 1. The wiring substrate 1 according to the first embodiment includes an insulating substrate 2. The insulating substrate 2 is made of, for example, a ceramic such as an aluminum oxide-based sintered body (alumina ceramic), an aluminum nitride-based sintered body, a mullite-based sintered body, or a glass ceramic sintered body. The insulating substrate 2 is composed of a plurality of insulating layers.

As illustrated in FIGs. 1, 2, 4, 5, and 6, the insulating substrate 2 has a first surface 2a, a second surface 2b located on an opposite side to the first surface 2a, a recessed portion 21 opening to the second surface 2b, and a rectangular through hole 22 penetrating from a bottom surface of the recessed portion 21 to the first surface 2a. The recessed portion 21 of the insulating substrate 2 has a rectangular shape in a bottom view, and the size of the recessed portion 21 of the insulating substrate 2 is larger than the size of the through hole 22 of the insulating substrate 2. The through hole 22 of the insulating substrate 2 has a rectangular shape in a plan view, and is a hole for accommodating the electronic component 300. An inner peripheral surface of the recessed portion 21 of the insulating substrate 2 and an inner peripheral surface of the through hole 22 are parallel in a thickness direction of the insulating substrate 2, respectively. A shape of the recessed portion 21 of the insulating substrate 2 in a bottom view and a shape of the through hole 22 in a plan view are not limited to the rectangular shape, and may be each a shape other than the rectangular shape, such as a circular shape.

As illustrated in FIGs. 1, 4, and 5, the wiring substrate 1 includes an insulating frame body 3 located on the first surface 2a of the insulating substrate 2. The insulating frame body 3 is integrated with the insulating substrate 2, and is made of the same material as the insulating substrate 2. The insulating frame body 3 is composed of one or a plurality of insulating layers. The insulating frame body 3 has a through hole 31, and the through hole 31 has a step portion 32 on an opening side. The through hole 31 of the insulating frame body 3 communicates with the through hole 22 and the recessed portion 21 of the insulating substrate 2. The step portion 32 of the through hole 31 of the insulating frame body 3 has a rectangular shape in a plan view, and a portion of the through hole 31 of the insulating frame body 3 excluding the step portion 32 has a circular shape in a plan view. The size of the through hole 31 of the insulating frame body 3 is larger than that of the through hole 22 of the insulating substrate 2. The insulating frame body 3 need not have the step portion 32. The shape of the through hole 31 of the insulating frame body 3 in a plan view is not limited to the above-described shape, and may be appropriately changed.

As illustrated in FIGs. 2, 3, and 4, the wiring substrate 1 includes a wiring conductor for electrically connecting the electronic component 300 and a mother substrate 400, and the wiring conductor includes, for example, a first wiring conductor 4 and a second wiring conductor 5. The first wiring conductor 4 extends from the first surface 2a to the second surface 2b of the insulating substrate 2. The first wiring conductor 4 includes a first electrode 41 located on the first surface 2a of the insulating substrate 2, a first external electrode 42 located on the second surface 2b of the insulating substrate 2, and a first connection wiring 43 located inside the insulating substrate 2 and electrically connecting the first electrode 41 and the first external electrode 42. The first electrode 41 and the first external electrode 42 are wiring layers located on the surface of the insulating substrate 2. The first connection wiring 43 is a through conductor penetrating the two insulating layers. The first connection wiring 43 may include two through conductors penetrating through the two insulating layers, respectively, and a wiring layer located between the insulating layers and connecting the through conductors each other. The second wiring conductor 5 also extends from the first surface 2a to the second surface 2b of the insulating substrate 2. The second wiring conductor 5 includes a second electrode 51 located on the first surface 2a of the insulating substrate 2, a second external electrode 52 located on the second surface 2b of the insulating substrate 2, and a second connection wiring 53 electrically connecting the second electrode 51 and the second external electrode 52 to each other. The second electrode 51 and the second external electrode 52 are wiring layers of the second wiring conductor 5. The second connection wiring 53 is a through conductor penetrating the two insulating layers. The second connection wiring 53 may include two through conductors penetrating the two insulating layers, respectively, and a wiring layer located between the insulating layers and connecting the through conductors to each other.

The wiring conductors (the first wiring conductor 4 and the second wiring conductor 5) are made of metalized metal powder containing tungsten (W), molybdenum (Mo), manganese (Mn), silver (Ag), copper (Cu), or the like, as a component.

As illustrated in FIG. 9, the first electrode 41 is electrically connected to a first electrode of the electronic component 300 by, for example, a bonding wire W. The first external electrode 42 is electrically connected to a first electrode 410 of the mother substrate 400 via a solder S. The second electrode 51 is electrically connected to a second electrode of the electronic component 300 by, for example, a bonding wire W. The second external electrode 52 is electrically connected to a second electrode 420 of the mother substrate 400 via a solder S.

The number, configuration, shape, arrangement, and the like of the wiring conductors are not limited to the above-described example, and can be appropriately changed in accordance with the number, arrangement, and the like of the first electrode and the second electrode of the electronic component 300 to be mounted.

As illustrated in FIGs. 4, 7, and 8, the wiring substrate 1 includes a frame-shaped metal layer 6 as a frame-shaped metal portion located on the bottom surface of the recessed portion 21 of the insulating substrate 2. The frame-shaped metal layer 6 surrounds the through hole 22 of the insulating substrate 2. The frame-shaped metal layer 6 is made of the same metalized metal powder as the first wiring conductor 4 and the second wiring conductor 5.

The shape of the frame-shaped metal layer 6 in a bottom view may be the same shape as the bottom surface of the recessed portion 21 of the insulating substrate 2. An inner edge of the frame-shaped metal layer 6 may have a shape along a peripheral edge of the through hole 22 of the insulating substrate 2. An outer edge of the frame-shaped metal layer 6 may have a shape along an outer edge of the bottom surface of the recessed portion 21 of the insulating substrate 2. As illustrated in FIG. 8, the inner edge of the frame-shaped metal layer 6 coincides with the peripheral edge of the through hole 22 of the insulating substrate 2, and the outer edge of the frame-shaped metal layer 6 is one size smaller than the outer edge of the bottom surface of the recessed portion 21 of the insulating substrate 2, but the configuration is not limited thereto. The inner edge of the frame-shaped metal layer 6 may be one size larger than the through hole 22 of the insulating substrate 2 and away from the peripheral edge of the through hole 22 of the insulating substrate 2, and the outer edge of the frame-shaped metal layer 6 may extend to an outer edge of the bottom surface of the recessed portion 21 of the insulating substrate 2 and reach an inner side surface of the recessed portion 21 of the insulating substrate 2. A portion extending to the outer edge of the bottom surface of the recessed portion 21 of the insulating substrate 2 need not be the entire circumference but may be a part thereof.

As illustrated in FIGs. 4, 5, and 6, the wiring substrate 1 includes a rectangular plate-shaped heat dissipation member 7 for dissipating heat from the electronic component 300, and the heat dissipation member 7 is located in the recessed portion 21 of the insulating substrate 2 so as to close the through hole 22. The heat dissipation member 7 is made of a material having a high thermal conductivity, such as copper, copper-tungsten (Cu-W), or aluminum (Al). The heat dissipation member 7 is bonded to the frame-shaped metal layer 6 by a brazing material B. The heat dissipation member 7 has a component mounting surface 7a for mounting the electronic component 300 on the through hole 22 side of the insulating substrate 2. The shape of the heat dissipation member 7 is not limited to a rectangular plate shape and can be appropriately changed in accordance with the shape of the electronic component 300 or the like.

As illustrated in FIG. 9, the heat dissipation member 7 is electrically connected to a connection pad 430 of the mother substrate 400 via a solder S. The connection pad 430 of the mother substrate 400 may function as a ground that defines a reference potential. In this case, the heat dissipation member 7 functions as a ground terminal in the wiring substrate 1. In the example illustrated in FIG. 9, the electronic component 300 may have a ground electrode on a lower surface and may be electrically connected to the heat dissipation member 7, which is a ground terminal, by a conductive bonding material.

As illustrated in FIGs. 4, 7, and 8, the frame-shaped metal layer 6 has a projecting portion 61 protruding toward the heat dissipation member 7, and the projecting portion 61 may have an annular shape surrounding the through hole 22 of the insulating substrate 2. The projecting portion 61 of the frame-shaped metal layer 6 is located so as to overlap the heat dissipation member 7 over an entire circumference in a transparent plan view. A part of the projecting portion 61 of the frame-shaped metal layer 6 may protrude from the heat dissipation member 7 in a transparent plan view.

As shown in FIGs. 1 and 4, when the insulating substrate 2 is made of, for example, an aluminum oxide-based sintered body, the insulating substrate 2 is produced in the following manner. An appropriate organic binder, a solvent and the like are added to and mixed with a raw material powder of aluminum oxide, silicon oxide or the like to produce a slurry. A ceramic green sheet for an insulating layer is produced by forming the slurry into a sheet shape by a doctor blade method, a calender roll method, or the like. Thereafter, the ceramic green sheet for an insulating layer is subjected to appropriate punching for forming holes such as the recessed portion 21 and the through hole 22 of the insulating substrate 2, and a plurality of ceramic green sheets for an insulating layer are layered to produce a laminate body (powder compact) for an insulating substrate. The laminate body for an insulating substrate is fired at a temperature of from 1300°C to 1600°C to produce the insulating substrate 2.

As in the case of the insulating substrate 2, the insulating frame body 3 is formed by appropriately punching a ceramic green sheet for an insulating layer, layering a plurality of ceramic green sheets for an insulating layer to produce a laminate body (powder compact) for an insulating frame body, and layering the laminate body on the laminate body for an insulating substrate. Then, the laminate body for an insulating frame body is fired at a high temperature together with the laminate body for an insulating substrate, whereby the insulating frame body 3 is produced simultaneously with the insulating substrate 2.

The first wiring conductor 4, the second wiring conductor 5, and the frame-shaped metal layer 6 can be formed as below when they are, for example, metalized layers of tungsten. The wiring layer of the first wiring conductor 4, the wiring layer of the second wiring conductor 5, and the frame-shaped metal layer 6 are formed by a method of printing a metal paste produced by mixing powder of tungsten with an organic solvent and an organic binder at a predetermined position on a ceramic green sheet for an insulating layer by a method such as a screen printing method, and then performing firing. The through conductor of the first wiring conductor 4 and the through conductor of the second wiring conductor 5 are formed by providing a hole for the through conductor at a predetermined position of a ceramic green sheet for an insulating layer and filling the hole for the through conductor with a metal paste. The projecting portion 61 of the frame-shaped metal layer 6 can be formed by, for example, overlap printing a metal paste on the metal paste printed in a shape of the frame-shaped metal layer 6. The height of the projecting portion 61 can be adjusted by, for example, changing a printing thickness of the metal paste or the number of times overlap printing is performed. The height of the projecting portion 61 (the difference in thickness between the projecting portion 61 and the other portion of the frame-shaped metal layer 6) may be set to be from 10 µm to 50 µm by setting a thickness of one printing to be, for example, from 10 µm to 50 µm.

A nickel plating layer/gold plating layer as a metal plating layer may be deposited on externally exposed surfaces of the first wiring conductor 4, the second wiring conductor 5, the frame-shaped metal layer 6, and the heat dissipation member 7 by a plating method such as an electrolytic plating method or an electroless plating method. Consequently, corrosion of the first wiring conductor 4, the second wiring conductor 5, and the like can be effectively reduced. The metal plating layer is not limited to the nickel plating layer/gold plating layer, and may be another metal plating layer including a nickel plating layer/palladium plating layer/gold plating layer, or the like.

As the brazing material B for bonding the heat dissipation member 7 to the frame-shaped metal layer 6, for example, a silver-copper (Ag-Cu) brazing material can be used. The brazing and soldering of the heat dissipation member 7 is performed in a state in which the second surface 2b of the insulating substrate 2 faces upward. For example, a frame-shaped brazing material preform is placed on the frame-shaped metal layer 6, the brazing material preform is melted by heating in a state in which the heat dissipation member 7 is placed thereon, and the brazing material preform is cooled, whereby the heat dissipation member 7 is bonded to the frame-shaped metal layer 6 with the brazing material B. Alternatively, a clad material in which the brazing material B is bonded to one surface (component mounting surface 7a) of the heat dissipation member 7 may be used. The heat dissipation member 7 to which the brazing material B is bonded (clad) is heated in a state in which the heat dissipation member 7 is placed on the frame-shaped metal layer 6 with the brazing material B facing downward to melt the brazing material B, and is cooled, whereby the heat dissipation member 7 is bonded to the frame-shaped metal layer 6 with the brazing material B. When the clad material is used, in the step of bonding the heat dissipation member 7 to the frame-shaped metal layer 6, a step of positioning and disposing the brazing material B is omitted, so that the productivity of the wiring substrate 1 is improved. When the brazing material preform is used, the likelihood of the flatness of the component mounting surface 7a of the heat dissipation member 7 being lowered by the brazing material B is reduced. In either method, the melted brazing material B wets, spreads and is bonded on the frame-shaped metal layer 6. The metal plating layer is deposited on the surface of the frame-shaped metal layer 6, whereby the melted brazing material B is more likely to wet and spread along the frame-shaped metal layer 6.

As shown in FIGs. 1, 2, and 4, the electronic device 200 includes the wiring substrate 1 and the electronic component 300 mounted on the wiring substrate 1. The electronic component 300 is, for example, a light emitting element such as a light emitting diode (LED) or a vertical cavity surface emitting laser (VCSEL) type laser diode, a light receiving element such as a photodiode, a semiconductor element such as an IC chip, or the like. The electronic component 300 is mounted on the component mounting surface 7a of the heat dissipation member 7, and is located in the through hole 22 of the insulating substrate 2. The electronic component 300 may protrude with respect to the first surface 2a of the insulating substrate 2. After the heat dissipation member 7 is brazed to the frame-shaped metal layer 6, the electronic component 300 is bonded to the component mounting surface 7a of the heat dissipation member 7 by a bonding material such as a resin adhesive, a conductive adhesive, or a low-melting-point brazing material. A first electrode of the electronic component 300 is electrically connected to the first electrode 41 of the first wiring conductor 4 by, for example, a bonding wire W. A second electrode of the electronic component 300 is electrically connected to the second electrode 51 of the second wiring conductor 5 by, for example, a bonding wire W.

As illustrated in FIGs. 1, 2, and 4, the electronic device 200 includes a lid 8 that closes the opening of the through hole 31 of the insulating frame body 3, and the lid 8 is bonded to the step portion 32 of the through hole 31 of the insulating frame body 3 by a bonding material such as a resin adhesive. When the electronic component 300 is an optical element such as a light emitting element or a light receiving element, the lid 8 is made of a translucent material such as glass or resin. In this case, as illustrated in FIGs. 1, 2, and 4, the lid 8 may have a lens shape and function as a lens, or may have a flat plate shape simply functioning as a translucent member. When the electronic component 300 is a semiconductor element or the like other than an optical element, the lid 8 may be made of metal or ceramic and have a flat plate shape.

In the case where the insulating frame body 3 has the step portion 32, the lid 8 is easily positioned, and the lid 8 is bonded to a side surface of the lid 8, so that the bonding strength of the lid 8 is increased. Since the thickness is increased by the thickness of the upper insulating layer, the strength of the wiring substrate 1 is also increased.

When the wiring substrate 1 includes the insulating frame body 3, a low-cost flat plate-shaped lid can be used, and a space for accommodating the electronic component 300 and the bonding wire W can be formed even for the flat plate-shaped lid.

According to the configuration of the wiring substrate 1 of the first embodiment, as described above, the frame-shaped metal layer 6 has the projecting portion 61 protruding toward the heat dissipation member 7 side, and the projecting portion 61 of the frame-shaped metal layer 6 is located so as to overlap the heat dissipation member 7 in a transparent plan view. For this reason, when a space for holding the brazing material B is formed between the heat dissipation member 7 and the frame-shaped metal layer 6 and the heat dissipation member 7 is brazed to the frame-shaped metal layer 6, outflow of the brazing material B to the component mounting surface 7a side of the heat dissipation member 7 can be reduced. The projecting portion 61 of the frame-shaped metal layer 6 can support the heat dissipation member 7, and when brazing the heat dissipation member 7 to the frame-shaped metal layer 6, an amount of the brazing material B pushed out toward the component mounting surface 7a side of the heat dissipation member 7 by the weight of the heat dissipation member 7 can be reduced.

Therefore, according to the wiring substrate 1 of the first embodiment, the brazing material B is not located on the component mounting surface 7a of the heat dissipation member 7, or the amount of the brazing material B located on the component mounting surface 7a of the heat dissipation member 7 can be reduced. Therefore, according to the wiring substrate 1 of the first embodiment, the flatness of the component mounting surface 7a of the heat dissipation member 7 can be improved. Consequently, the connection reliability between the wiring substrate 1 and the electronic component 300 can be enhanced, and at the same time, the heat dissipation property can be improved.

In the case where the projecting portion 61 of the frame-shaped metal layer 6 has an annular shape surrounding the through hole 22 of the insulating substrate 2 and the brazing material B is preformed, the brazing material B located outside the projecting portion 61 is blocked by the projecting portion 61 of the frame-shaped metal layer 6 when brazing the heat dissipation member 7 to the frame-shaped metal layer 6. In order to further enhance the effect of blocking the brazing material, an inner dimension of the frame-shaped preform may be set to be equal to or larger than an inner dimension of the annular projecting portion 61. As in the example illustrated in FIG. 8, a width of a portion of the frame-shaped metal layer 6 outside the projecting portion 61 may be set larger than a width of a portion of the frame-shaped metal layer 6 inside the projecting portion 61. The brazing material B located inside the projecting portion 61 is held in the space between the frame-shaped metal layer 6 and the heat dissipation member 7. Consequently, the outflow of the brazing material B to the component mounting surface 7a side of the heat dissipation member 7 can be further reduced, and the flatness of the component mounting surface 7a of the heat dissipation member 7 is further improved.

When a clad material is used as the brazing material B, in order to form a larger space inside the annular projecting portion 61, the annular projecting portion 61 may have a shape overlapping an outer peripheral portion of the heat dissipation member 7 (having a large inner dimension). The distance from the inner edge of the frame-shaped metal layer 6 to the inner edge of the projecting portion 61 may be set larger than the distance from the outer edge of the frame-shaped metal layer 6 to the outer edge of the projecting portion 61. In other words, the width of the portion of the frame-shaped metal layer 6 inside the projecting portion 61 may be set larger than the width of the portion of the frame-shaped metal layer 6 outside the projecting portion 61. Consequently, the space for holding the brazing material B by the heat dissipation member 7 and the frame-shaped metal layer 6 can be increased on the inner side of the projecting portion 61, and the brazing material B is likely to flow out from the component mounting surface 7a of the heat dissipation member 7 toward the outside.

The frame-shaped metal layer 6 may have a groove (a portion having a low height) extending from the inner side to the outer side so that the brazing material B flows from the inner side toward the outer side of the annular projecting portion 61. When a plurality of grooves are provided at intervals in the circumferential direction, the brazing material B spreads outward over the entire circumference of the frame-shaped metal layer 6.

### Second Embodiment

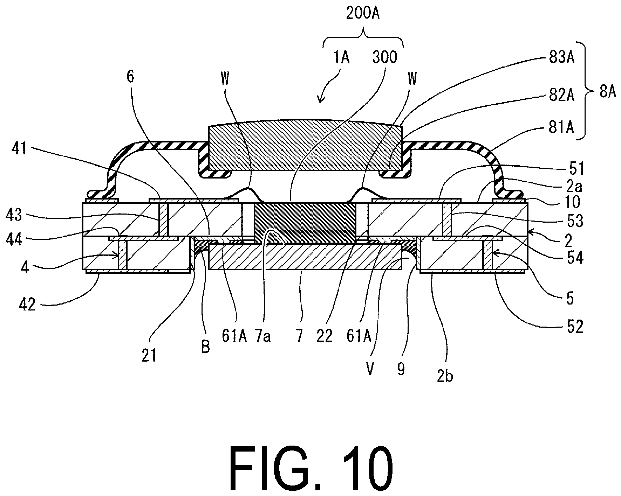

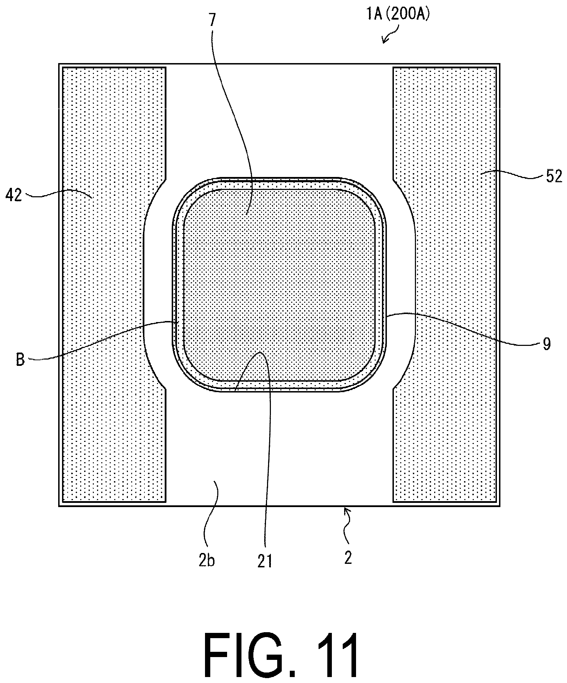

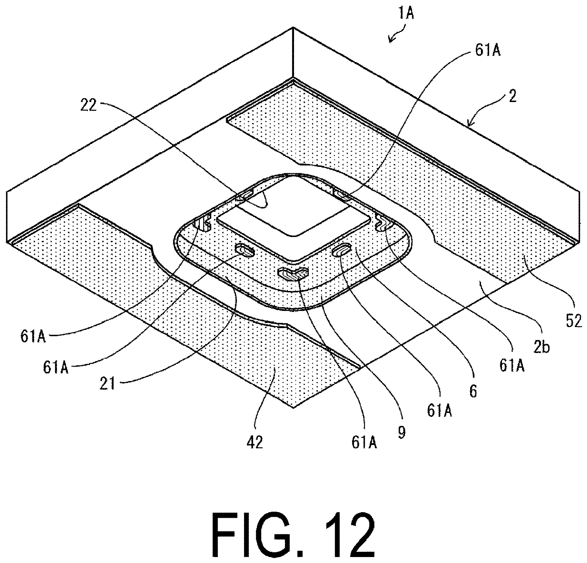

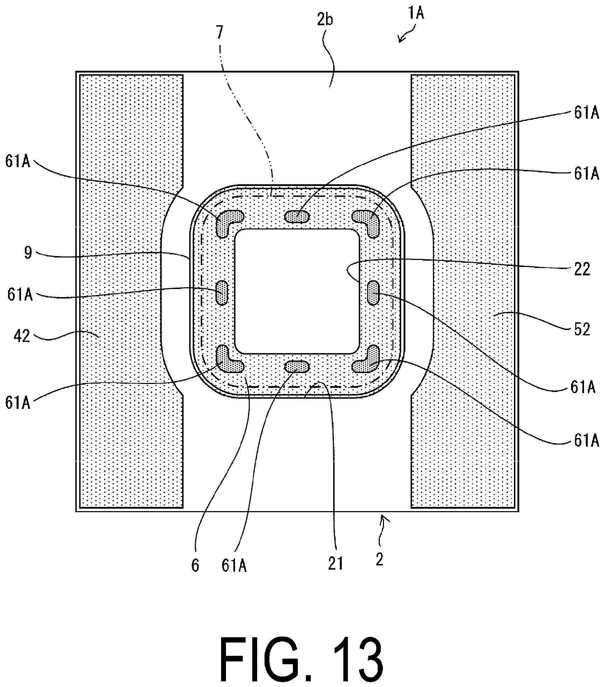

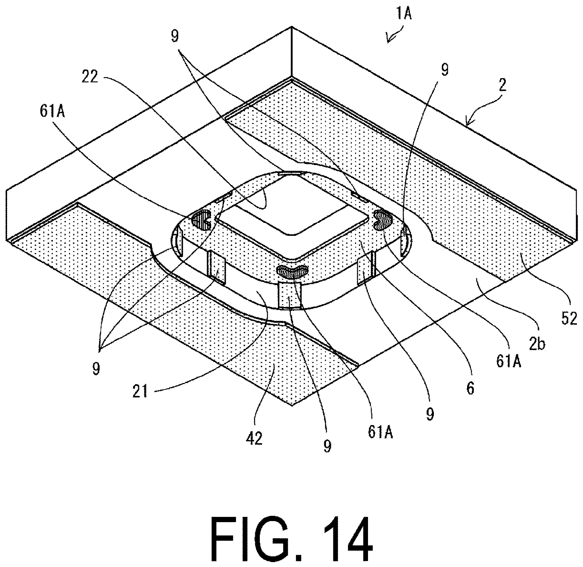

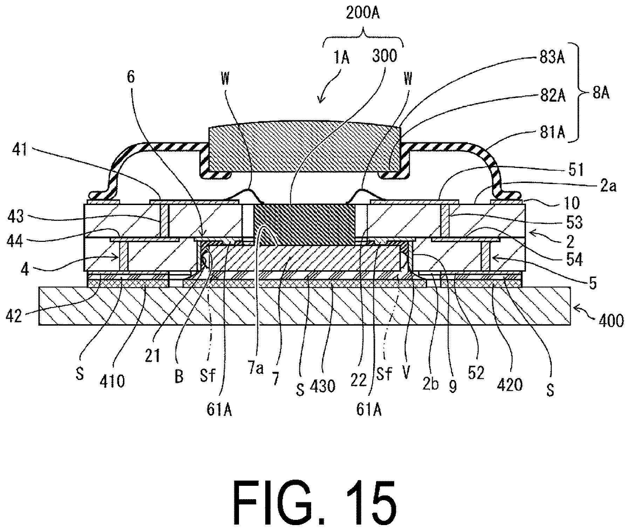

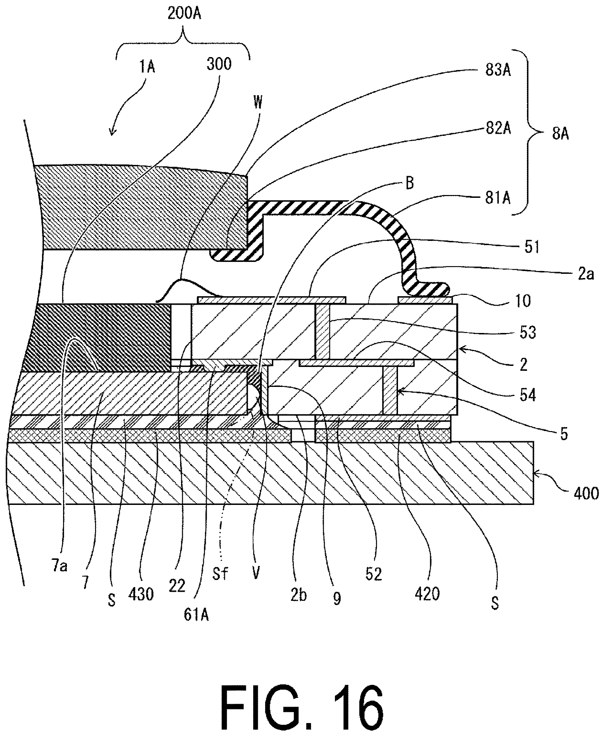

A second embodiment will be described below with reference to FIGs. 10 to 15. FIG. 10 is a schematic cross-sectional view of an electronic device according to a second embodiment. FIG. 11 is a schematic bottom view of the electronic device illustrated in FIG. 10. FIG. 12 is a schematic perspective view of a wiring substrate according to the second embodiment as viewed from a second surface side of an insulating substrate, illustrating a state in which a heat dissipation member is removed. FIG. 13 is a schematic bottom view of the wiring substrate illustrated in FIG. 12, illustrating a state in which the heat dissipation member is removed. FIG. 14 is a schematic perspective view of another example of the wiring substrate according to the second embodiment as viewed from the second surface side of the insulating substrate, illustrating a state in which a plurality of side-surface metal layers are located at intervals in a circumferential direction of an inner peripheral surface of a recessed portion of the insulating substrate. FIG. 15 is a schematic cross-sectional view illustrating a state in which the electronic device illustrated in FIG. 10 is mounted on a mother substrate. FIG. 16 is a schematic partial enlarged cross-sectional view illustrating a state in which the electronic device illustrated in FIG. 10 is mounted on the mother substrate.

As illustrated in FIGs. 10 and 11, an electronic device 200A according to the second embodiment includes a wiring substrate 1A according to the second embodiment and an electronic component 300 mounted on the wiring substrate 1. Except for some configurations, the wiring substrate 1A according to the second embodiment has the same configuration as that of the wiring substrate 1 according to the first embodiment. In the configuration of the wiring substrate 1A according to the second embodiment, a configuration different from that of the wiring substrate 1 according to the first embodiment will be described. For convenience of description, a member having the same function as that of a member described in the first embodiment is denoted by the same reference sign.

As illustrated in FIG. 10, the wiring substrate 1A according to the second embodiment need not include the insulating frame body 3 of the first embodiment and may be formed in a flat plate shape.

As illustrated in FIGs. 10, 12, and 13, the frame-shaped metal layer 6 as the frame-shaped metal portion may have a plurality of projecting portions 61A protruding toward the heat dissipation member 7, and the plurality of projecting portions 61A may be located at intervals in the circumferential direction of the frame-shaped metal layer 6. The plurality of projecting portions 61A of the frame-shaped metal layer 6 are located so as to overlap the heat dissipation member 7 in a transparent plan view. In the example illustrated in FIG. 13, the entirety of each projecting portion 61A of the frame-shaped metal layer 6 is located so as to overlap the heat dissipation member 7 in a transparent plan view. At least a part of each projecting portion 61A of the frame-shaped metal layer 6 may be located so as to overlap the heat dissipation member 7 in a transparent plan view. In other words, a part of each projecting portion 61A of the frame-shaped metal layer 6 may protrude from the heat dissipation member 7 in a transparent plan view. The frame-shaped metal layer 6 may have one or a plurality of second projecting portions (not illustrated) that do not overlap the heat dissipation member 7 in a transparent plan view, in addition to the projecting portions 61A. It can be said that the projecting portion 61A of the second embodiment has a shape obtained by dividing the annular projecting portion 61 of the first embodiment. The L-shaped projecting portions 61A are located near four corner portions of the rectangular through hole 22, respectively, and the linear projecting portions 61A are located near four side portions of the rectangular through hole 22, respectively. In this way, the plurality of projecting portions 61A need not all have the same shape and the same size. For example, as illustrated in FIG. 14, the projecting portions 61A may be located only near the four corner portions of the through hole 22, or may be located only near the four side portions. The number and arrangement of the projecting portions 61A may be set such that the heat dissipation member 7 can be supported without being inclined when brazing the heat dissipation member 7 to the frame-shaped metal layer 6.

As illustrated in FIGs. 10, 12, and 13, the wiring substrate 1A may include a side-surface metal layer 9 as a side-surface metal portion located on the inner peripheral surface of the recessed portion 21 of the insulating substrate 2. The side-surface metal layer 9 is made of the same metalized metal powder as the first wiring conductor 4, the second wiring conductor 5, and the like. The side-surface metal layer 9 may have an annular shape located over the entire circumference of the inner peripheral surface of the recessed portion 21 of the insulating substrate 2. The side-surface metal layer 9 may be connected to the frame-shaped metal layer 6 and extend from the bottom surface side toward the opening side of the recessed portion 21 of the insulating substrate 2. The side-surface metal layer 9 may extend to an opening end of the recessed portion 21 of the insulating substrate 2. The brazing material B for bonding the heat dissipation member 7 extends from the frame-shaped metal layer 6 to the side-surface metal layer 9.

As illustrated in FIG. 14, the number of side-surface metal layers 9 as side-surface metal portions may be plural, and the plurality of side-surface metal layers 9 may be located at intervals in the circumferential direction of the inner peripheral surface of the recessed portion 21 of the insulating substrate 2. The side-surface metal layer 9 can be formed as a metalized layer by printing and firing a metal paste on an inner surface of a through hole of a ceramic green sheet to be the recessed portion 21.

As illustrated in FIGs. 10, 15, and 16, a space V may be present between the outer peripheral surface of the heat dissipation member 7 and the side-surface metal layer 9 on the opening side of the recessed portion 21 of the insulating substrate 2. Even when the solder S creeps up the side-surface metal layer 9 at the time of solder-mounting the wiring substrate 1A onto the mother substrate 400, the space V may be present between the outer peripheral surface of the heat dissipation member 7 and the side-surface metal layer 9 on the opening side of the recessed portion 21 of the insulating substrate 2.

As illustrated in FIG. 10, the first connection wiring 43 of the first wiring conductor 4 may include two through conductors, i.e., a through conductor penetrating the upper insulating layer and a through conductor penetrating the lower insulating layer. In this case, the two through conductors are connected by a first connection wiring layer 44 located between the upper and lower insulating layers. The first connection wiring layer 44 is a wiring layer of the first wiring conductor 4. The second connection wiring 53 of the second wiring conductor 5 may also include two through conductors, i.e., a through conductor penetrating the upper insulating layer and a through conductor penetrating the lower insulating layer. The two through conductors of the second wiring conductor 5 are connected by a second connection wiring layer 54 located between the upper and lower insulating layers. The second connection wiring layer 54 is a wiring layer of the second wiring conductor 5.

As illustrated in FIG. 10, a nickel plating layer/gold plating layer as a metal plating layer may be deposited on externally exposed surfaces of the first wiring conductor 4, the second wiring conductor 5, the frame-shaped metal layer 6, the heat dissipation member 7 and the side-surface metal layer 9 by a plating method such as an electrolytic plating method or an electroless plating method. Consequently, corrosion of the first wiring conductor 4, the second wiring conductor 5, and the like can be effectively reduced.

The electronic device 200A, instead of including the insulating frame body 3 and the lid 8 (refer to FIG. 4), has the following configuration.

As illustrated in FIG. 10, the wiring substrate 1A of the electronic device 200A may include a metalized layer 10 located at the peripheral edge portion of the first surface 21 of the insulating substrate 2, and the metalized layer 10 is made of the same metalized metal powder as those of the first wiring conductor 4, the second wiring conductor 5, and the like. The metalized layer 10 is formed by the same method as the wiring layer of the first wiring conductor 4, the wiring layer of the second wiring conductor 5, and the like. A metal frame body may be further provided on the metalized layer 10. When the metalized layer 10 and the metal frame body are provided, a lid 8A can be easily bonded by brazing and soldering, or welding such as resistance welding.

When the wiring substrate 1A does not include the insulating frame body 3, the electronic device 200A may include the cap-shaped lid 8A. The lid 8A has a cap-shaped lid main body 81A bonded to the metalized layer 10, and the lid main body 81A is made of, for example, metal having a small difference in thermal expansion coefficient from a ceramic such as an iron-nickel (Fe-Ni) alloy or an iron-nickel-cobalt (Fe-Ni-Co) alloy. The lid main body 81A may also be made of a ceramic other than metal. When the lid main body 81A is made of a metal, the lid main body 81A can be produced by pressing a metal plate. When the lid main body 81A is made of a ceramic, a laminate of ceramic green sheets may be fired in the same manner as the insulating substrate 2, or ceramic powder may be press-molded into a cap shape and then fired.

When the electronic component 300 is an optical element, as in the example illustrated in FIG. 10, the lid 8A may include a cap-shaped lid main body 81A having an opening portion and a window member 83A closing the opening portion of the lid main body 81A. The lid main body 81A may have, at a center thereof, a step portion 82A having an annular shape in a plan view for positioning and holding the window member 83. When the lid main body 81A does not have the step portion 82A, the opening portion of the lid main body 81A may be closed from the outside or the inside. The window member 83A transmits light emitted or received by the optical element, and is made of a translucent material such as glass. The window member 83A may have a lens shape as in the example illustrated in FIG. 10, or may have a flat plate shape. When the electronic component 300 is a semiconductor element or the like other than an optical element, the window member 83A may be made of a metal or a ceramic and have a flat plate shape. The window member 83A is bonded to the lid main body 81A with a bonding material made of, for example, resin, glass, or the like. In the figure, the lid main body 81A has the opening portion, but when the electronic component 300 is not an optical element, the lid main body may have a cap shape without an opening portion.

According to the configuration of the wiring substrate 1A of the second embodiment, as described above, the frame-shaped metal layer 6 has the plurality of projecting portions 61A protruding toward the heat dissipation member 7 side, and the plurality of projecting portions 61A are located so as to overlap the heat dissipation member 7 in a transparent plan view. For this reason, when a space for holding the brazing material B is formed between the heat dissipation member 7 and the frame-shaped metal layer 6 and the heat dissipation member 7 is brazed to the frame-shaped metal layer 6, outflow of the brazing material B to the component mounting surface 7a side of the heat dissipation member 7 can be reduced. The projecting portion 61 of the frame-shaped metal layer 6 can support the heat dissipation member 7, and when brazing the heat dissipation member 7 to the frame-shaped metal layer 6, the amount of the brazing material B pushed out toward the component mounting surface 7a side of the heat dissipation member 7 by the weight of the heat dissipation member 7 can be reduced.

Therefore, according to the wiring substrate 1A of the second embodiment, the brazing material B is not located on the component mounting surface 7a of the heat dissipation member 7, or the amount of the brazing material B located on the component mounting surface 7a of the heat dissipation member 7 can be reduced. Therefore, according to the wiring substrate 1A of the second embodiment, the flatness of the component mounting surface 7a of the heat dissipation member 7 can be improved. Consequently, the connection reliability between the wiring substrate 1A and the electronic component 300 can be enhanced, and at the same time, the heat dissipation property can be improved.

In the case where the plurality of projecting portions 61A of the frame-shaped metal layer 6 are located at intervals in the circumferential direction of the frame-shaped metal layer 6, the space for holding the brazing material B between the heat dissipation member 7 and the frame-shaped metal layer 6 is larger than in the case where the projecting portion 61 is annular. Consequently, when brazing the heat dissipation member 7 to the frame-shaped metal layer 6, the outflow of the brazing material B toward the component mounting surface 7a side of the heat dissipation member 7 can be further reduced. In particular, when the brazing material B is clad, a flow path of the brazing material B can be formed between the projecting portions 61A adjacent to each other in the circumferential direction, and when brazing the heat dissipation member 7 to the frame-shaped metal layer 6, the brazing material B is likely to flow out from a central portion (component mounting surface 7a) of the heat dissipation member 7 to the outer edge side of the frame-shaped metal layer 6 through the flow path. Therefore, according to the wiring substrate 1A of the second embodiment, the flatness of the component mounting surface 7a of the heat dissipation member 7 can be further improved.

Since the brazing material B flows out from the central portion of the heat dissipation member 7 to the outside even when the part inside the projecting portion 61A of the frame-shaped metal layer 6 (part outside the through hole 22 of the heat dissipation member 7) is not made large, the size of the wiring substrate 1A is not increased.

When the plurality of projecting portions 61A of the frame-shaped metal layer 6 are located at intervals in the circumferential direction of the frame-shaped metal layer 6, the amount of the brazing material B held between the heat dissipation member 7 and the frame-shaped metal layer 6 can be increased. Consequently, according to the wiring substrate 1A of the second embodiment, the bonding strength between the heat dissipation member 7 and the frame-shaped metal layer 6 is enhanced, and the stress of the insulating substrate 2 caused due to the difference in thermal expansion between the heat dissipation member 7 and the insulating substrate 2 is relaxed.

When the side-surface metal layer 9 is located on the inner peripheral surface of the recessed portion 21 of the insulating substrate 2, the brazing material B wets and spreads to the side-surface metal layer 9 connected to the frame-shaped metal layer 6. Consequently, when brazing the heat dissipation member 7 to the frame-shaped metal layer 6, the outflow of the brazing material B toward the component mounting surface 7a side of the heat dissipation member 7 can be further reduced, or the outflow of the brazing material B from the component mounting surface 7a of the heat dissipation member 7 toward the outside can be further increased. Therefore, according to the wiring substrate 1A of the second embodiment, the flatness of the component mounting surface 7a of the heat dissipation member 7 can be further improved.

When the side-surface metal layer 9 is located on the inner peripheral surface of the recessed portion 21 of the insulating substrate 2, the holding amount of the brazing material B can be increased even if a layer width of the frame-shaped metal layer 6 (a protruding length of the frame-shaped metal layer 6 with respect to the inner peripheral surface of the recessed portion 21 of the insulating substrate 2) is reduced. Consequently, according to the wiring substrate 1A of the second embodiment, the recessed portion 21 of the insulating substrate 2 can be reduced in size.

In the case where the side-surface metal layer 9 has an annular shape located over the entire circumference of the inner peripheral surface of the recessed portion 21 of the insulating substrate 2, when brazing the heat dissipation member 7 to the frame-shaped metal layer 6, the amount of the brazing material B flowing toward the side-surface metal layer 9 is increased, and the holding amount of the brazing material B between the heat dissipation member 7 and the recessed portion 21 of the insulating substrate 2 can be increased. Consequently, according to the wiring substrate 1A of the second embodiment, the bonding strength between the heat dissipation member 7 and the frame-shaped metal layer 6 is further enhanced, and the stress of the insulating substrate 2 caused due to the difference in thermal expansion between the heat dissipation member 7 and the insulating substrate 2 is further relaxed.

When the plurality of side-surface metal layers 9 are located at intervals in the circumferential direction of the inner peripheral surface of the recessed portion 21 of the insulating substrate 2, regions without the brazing material B are present at intervals in the circumferential direction between the outer peripheral surface of the heat dissipation member 7 and the inner peripheral surface of the recessed portion 21 of the insulating substrate 2. Consequently, the stress of the insulating substrate 2 caused due to the difference in thermal expansion between the heat dissipation member 7 and the insulating substrate 2 is relaxed, and the heat dissipation property from the brazing material B around the heat dissipation member 7 is improved.

In the case where the side-surface metal layer 9 extends to the opening end of the recessed portion 21 of the insulating substrate 2, as compared with a case where the side-surface metal layer 9 extends to the middle of the depth of the recessed portion 21 of the insulating substrate 2, even if the side-surface metal layer 9 is annular or a plurality of side-surface metal layers 9 are located at intervals in the circumferential direction, an area of the side-surface metal layer 9 and the amount of the brazing material B flowing toward the side-surface metal layer 9 are increased, and the holding amount of the brazing material B can be increased. When the annular side-surface metal layer 9 extends to the opening end of the recessed portion 21 of the insulating substrate 2, the holding amount of the brazing material B can be further increased.

In the case where the side-surface metal layer 9 extends to the opening end of the recessed portion 21 of the insulating substrate 2, as illustrated in FIGs. 15 and 16, when solder-mounting the wiring substrate 1A onto the mother substrate 400, the solder S creeps up the side-surface metal layer 9 to form a solder fillet Sf extending from the side-surface metal layer 9 toward a center side of the recessed portion 21 of the insulating substrate 2. Consequently, the solder S comes into contact with the heat dissipation member 7, and the heat dissipation member 7 is easily bonded to the connection pad 430 of the mother substrate 400.

Specifically, even if there is a variation in the position of the lower surface of the heat dissipation member 7, bonding can be performed more reliably. In particular, in the case where the lower surface of the heat dissipation member 7 is located above (on the first surface 2a side of) the lower surfaces of the external electrodes 42.52, when mounting the electronic device 200A (wiring substrate 1A) onto the mother substrate 400, the solder S on the connection pad 430 of the mother substrate 400 may not contact the heat dissipation member 7, and the heat dissipation member 7 may not be bonded to the connection pad 430. Since the side-surface metal layer 9 extends to the opening end of the recessed portion 21 of the insulating substrate 2, the solder S comes into contact with and creeps up the side-surface metal layer 9 to form the solder fillet Sf. The solder fillet Sf spreading from the side-surface metal layer 9 toward the heat dissipation member 7 comes into contact with the heat dissipation member 7 and further wets and spreads to the lower surface of the heat dissipation member 7, whereby the heat dissipation member 7 is bonded to the connection pad 430 of the mother substrate 400.

In order to achieve more reliable bonding by the solder fillet Sf, a distance from the lower surface of the external electrodes 42, 52 to the lower surface of the heat dissipation member 7 may be set to 50 µm or less. If the lower surface of the heat dissipation member 7 excessively protrudes downward beyond the lower surface of the external electrodes 42, 52, the external electrodes 42, 52 may have a connection failure. Therefore, the projecting amount may be set to 100 µm or less.

The connection pad 430 of the mother substrate 400 may be larger than the through hole 22 (side-surface metal layer 9) of the insulating substrate 2 in a plan view, and may have such a size that an outer edge is located outside the through hole 22 of the insulating substrate 2. The amount of the solder S for forming the solder fillet Sf is increased by the amount of the solder S located outside the through hole 22 (side-surface metal layer 9) of the insulating substrate 2. As a result, the solder S creeps up the side-surface metal layer 9, and the solder fillet Sf is easily formed. In other words, a larger solder fillet Sf that is more easily connected by the heat dissipation member 7 is more easily formed.

In the case where the space V is present between the outer peripheral surface of the heat dissipation member 7 and the side-surface metal layer 9 on the opening side of the recessed portion 21 of the insulating substrate 2, as illustrated in FIGs. 15 and 16, when solder-mounting the wiring substrate 1A onto the mother substrate 400, the solder S creeps up the side-surface metal layer 9, and the solder fillet Sf is easily formed. Consequently, the solder S comes into contact with the heat dissipation member 7, and the heat dissipation member 7 is more easily bonded to the connection pad 430 of the mother substrate 400. In order to achieve more reliable bonding by the solder fillet Sf, the width of the space V (the distance between the outer peripheral surface of the heat dissipation member 7 and the side-surface metal layer 9) may be set to be equal to or less than the thickness of the heat dissipation member 7.

### Third Embodiment

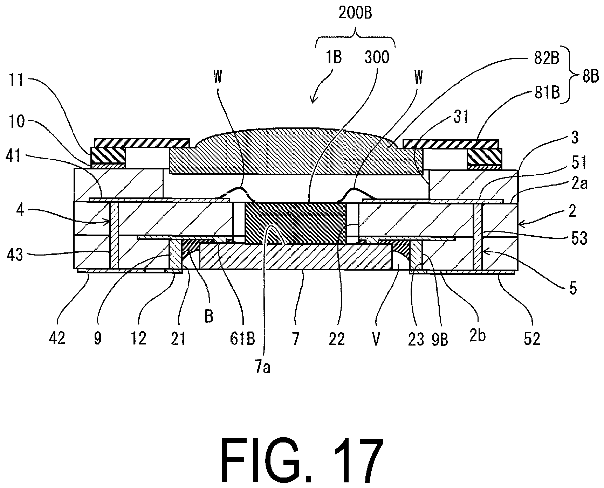

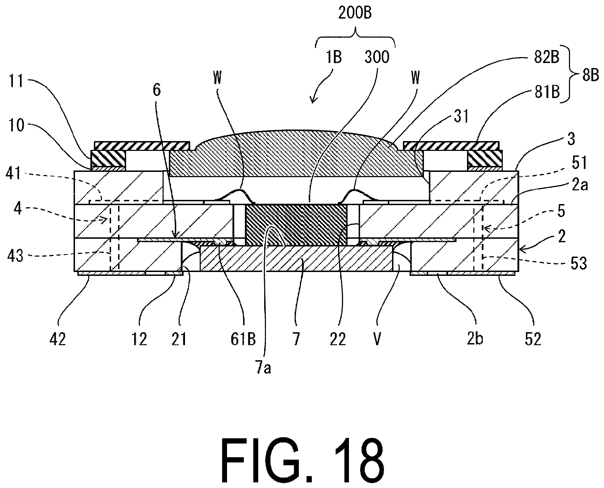

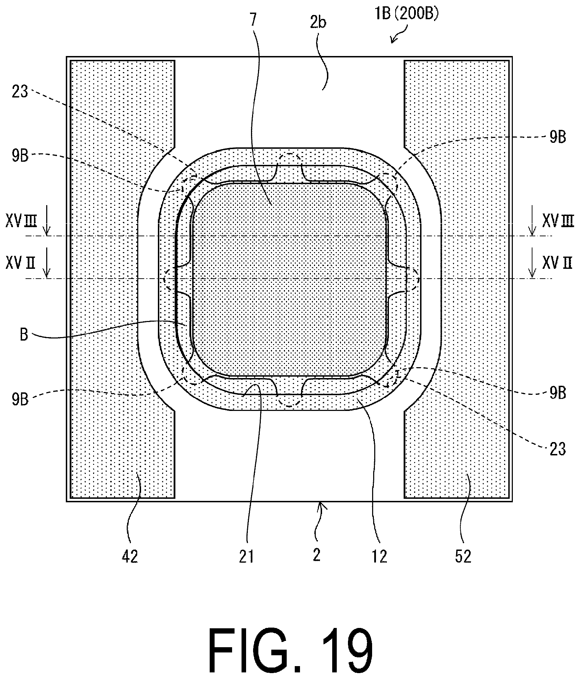

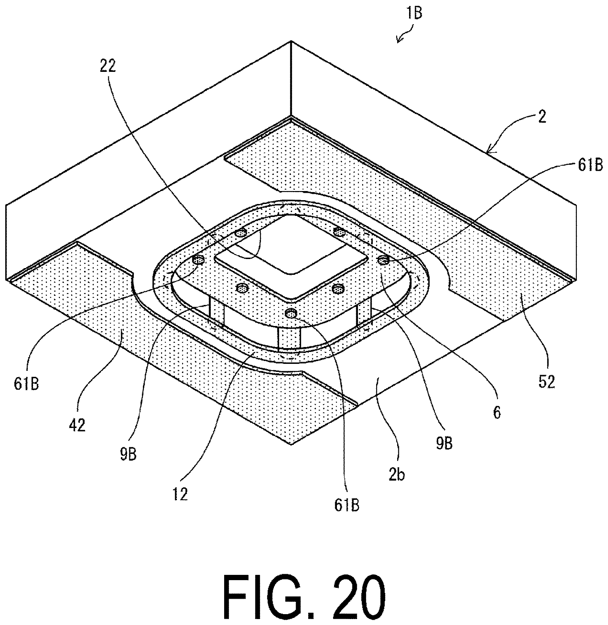

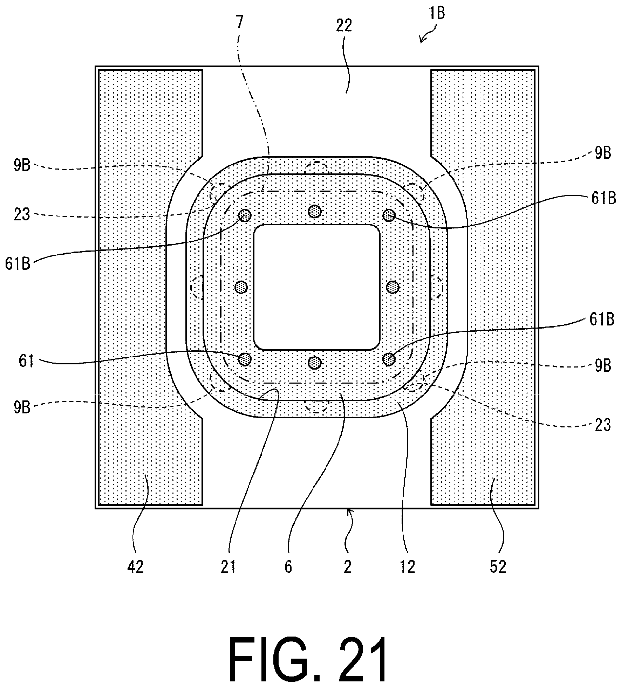

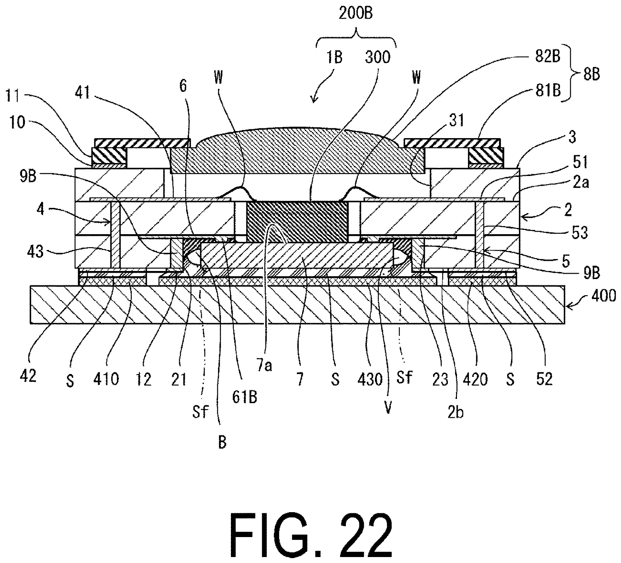

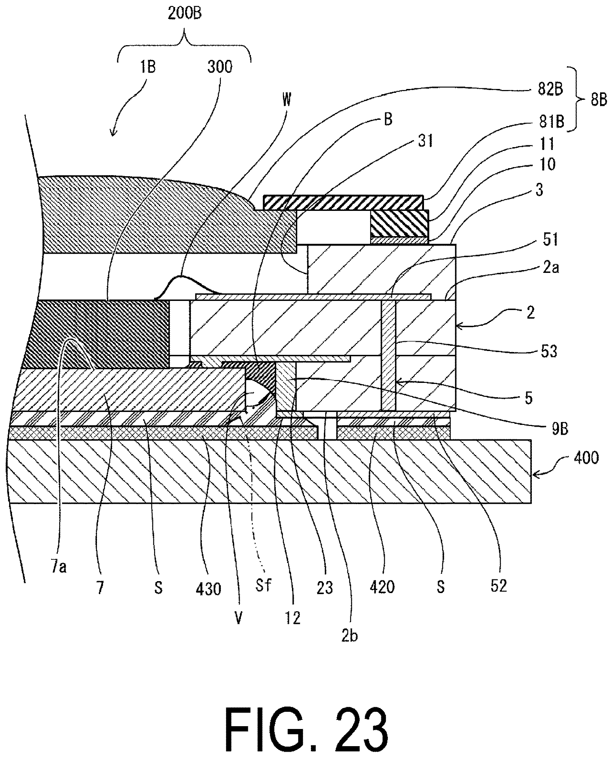

A third embodiment will be described below with reference to FIGs. 17 to 23. FIG. 17 is a schematic cross-sectional view taken along a line XVII-XVII in FIG. 19. FIG. 18 is a schematic cross-sectional view taken along a line XVIII-XVIII in FIG. 19. FIG. 19 is a schematic bottom view of an electronic device according to a third embodiment. FIG. 20 is a schematic perspective view of a wiring substrate according to the third embodiment as viewed from a second surface side of an insulating substrate, illustrating a state in which a heat dissipation member is removed. FIG. 21 is a schematic bottom view of the wiring substrate illustrated in FIG. 20, illustrating a state in which the heat dissipation member is removed. FIG. 22 is a schematic cross-sectional view illustrating a state in which the electronic device illustrated in FIG. 19 is mounted on a mother substrate. FIG. 23 is a schematic partial enlarged cross-sectional view illustrating a state in which the electronic device illustrated in FIG. 19 is mounted on the mother substrate.

As illustrated in FIGs. 17 to 19, an electronic device 200B according to the third embodiment includes a wiring substrate 1B according to the embodiment, and an electronic component 300 mounted on the wiring substrate 1B. Except for some configurations, the wiring substrate 1B according to the third embodiment has the same configuration as that of the wiring substrate 1 according to the first embodiment. In the configuration of the wiring substrate 1B according to the third embodiment, a configuration different from that of the wiring substrate 1 according to the first embodiment will be described. For convenience of description, a member having the same function as that of a member described in the first embodiment is denoted by the same reference sign.

The insulating frame body 3 is composed of one insulating layer, and the through hole 31 of the insulating frame body 3 does not have the step portion 32 (refer to FIG. 4). The wiring substrate 1B may include the metalized layer 10 located at the peripheral edge portion of the first surface 2a of the insulating substrate 2, and the metalized layer 10 is made of the same metalized metal powder as that of the first wiring conductor 4 and the second wiring conductor 5. The metalized layer 10 is formed by the same method as the wiring layer of the first wiring conductor 4, the wiring layer of the second wiring conductor 5, and the like. The wiring substrate 1B may further include a metal frame body 11 on the metalized layer 10. The metal frame body 11 is made of, for example, metal having a small difference in thermal expansion coefficient from a ceramic such as an iron-nickel (Fe-Ni) alloy or an iron-nickel-cobalt (Fe-Ni-Co) alloy. The metal frame body 11 is bonded to the metalized layer 10 by, for example, a brazing material.

As illustrated in FIGs. 17, 18, 20, and 21, the frame-shaped metal layer 6 as the frame-shaped metal portion may have a plurality of projecting portions 61B protruding toward the heat dissipation member 7, and the plurality of projecting portions 61B may be located at intervals in the circumferential direction of the frame-shaped metal layer 6. The plurality of projecting portions 61 of the frame-shaped metal layer 6 are located so as to overlap the heat dissipation member 7 in a transparent plan view. At least a part of each projecting portion 61B of the frame-shaped metal layer 6 is located so as to overlap the heat dissipation member 7 in a transparent plan view. In other words, a part of each projecting portion 61B of the frame-shaped metal layer 6 may protrude from the heat dissipation member 7 in a transparent plan view. The number and arrangement of the projecting portions 61B may be the same as the number and arrangement of the projecting portions 61A of the second embodiment. The projecting portion 61B may have a circular shape in a plan view and may be formed smaller than the projecting portion 61A of the second embodiment. In this case, the space for holding the brazing material B is larger, and the flow path from the component mounting surface 7a of the heat dissipation member 7 to the outside is larger. Since the projecting portion 61B has a circular shape in a plan view, the flow of the brazing material B from the component mounting surface 7a of the heat dissipation member 7 to the outside is less likely to be hindered, and the brazing material B easily goes around to the outside of the projecting portion 61B.

The frame-shaped metal layer 6 may have one or a plurality of second projecting portions (not illustrated) lower than the projecting portion 61B, in addition to the projecting portion 61B. The second projecting portion of the frame-shaped metal layer 6 need not overlap the heat dissipation member 7 in a transparent plan view.

As illustrated in FIGs. 17, 19, 20, and 21, the wiring substrate 1B may include a plurality of side-surface metal bodies 9B as side-surface metal portions located on the inner peripheral surface of the recessed portion 21 of the insulating substrate 2. The brazing material B for bonding the heat dissipation member 7 extends from the frame-shaped metal layer 6 to the side-surface metal layer 9. The side-surface metal bodies 9B are made of the same metalized metal powder as the first wiring conductor 4, the second wiring conductor 5, and the like. The side-surface metal bodies 9B may be located in a plurality of grooves 23 provided at intervals in the circumferential direction on the inner peripheral surface of the recessed portion 21 of the insulating substrate 2. In other words, the plurality of side-surface metal bodies 9B may be located at intervals in the circumferential direction of the inner peripheral surface of the recessed portion 21 of the insulating substrate 2. The plurality of side-surface metal bodies 9B may be formed by a metalized material filled in the plurality of grooves 23 of the insulating substrate 2. The side-surface metal bodies 9B are made of the same metalized metal powder as the first wiring conductor 4, the second wiring conductor 5, and the like. The side-surface metal bodies 9B may be connected to the frame-shaped metal layer 6 and extend from the bottom surface side toward the opening side of the recessed portion 21 of the insulating substrate 2. The side-surface metal bodies 9B may extend to the opening end of the recessed portion 21 of the insulating substrate 2.

As illustrated in FIGs. 17, 18, 22, and 23, a space V is present between the outer peripheral surface of the heat dissipation member 7 and the side-surface metal body 9B on the opening side of the recessed portion 21 of the insulating substrate 2. Even when the solder S creeps up the side-surface metal body 9B at the time of solder-mounting the wiring substrate 1B onto the mother substrate 400, the space V is present between the outer peripheral surface of the heat dissipation member 7 and the side-surface metal body 9B on the opening side of the recessed portion 21 of the insulating substrate 2.

Although not illustrated in the drawings, the wiring substrate 1B may be a side-surface metal layer (side-surface metalized layer) located along an inner surface of the groove 23 of the insulating substrate 2, instead of the side-surface metal body 9B in which the groove 23 is filled with a metalized material. When the side-surface metal body 9B or the side-surface metal layer is located in the plurality of grooves 23 of the insulating substrate 2, the bonding strength between the side-surface metal body 9B or the side-surface metal layer and the insulating substrate 2 is improved, as compared with a case where the plurality of side-surface metal layers 9 are provided on the inner side surface of the recessed portion 21 of the insulating substrate 2 without the groove 23 as in the example illustrated in FIG. 14. When the plurality of grooves 23 of the insulating substrate 2 are filled with the side-surface metal body 9B, heat transferred to the side-surface metal body 9B is easily transferred to the lower surface (easily heat-dissipated) because a cross-sectional area of the metalized layer is large. When the side-surface metal layer is located along the inner surface of the plurality of grooves 23 of the insulating substrate 2, the brazing material B enters the grooves 23 of the insulating substrate 2, so that the space for holding the brazing material B increases.

As illustrated in FIGs. 17 to 21, the wiring substrate 1B may include a second frame-shaped metal layer 12 as a second frame-shaped metal portion located on the second surface 2b of the insulating substrate 2. The second frame-shaped metal layer 12 is made of the same metalized metal powder as the first wiring conductor 4, the second wiring conductor 5, and the like. The second frame-shaped metal layer 12 surrounds the opening of the recessed portion 21 of the insulating substrate 2 and is connected to the plurality of side-surface metal bodies 9B.

The groove 23 of the insulating substrate 2 is formed by performing appropriate punching processing on a ceramic green sheet for an insulating layer, like the recessed portion 21 and the through hole 22 of the insulating substrate 2. When the side-surface metal body 9B is a metalized layer of tungsten, for example, the side-surface metal body 9B is formed by filling a metal paste in a hole corresponding to the groove 23 formed at a predetermined position of the ceramic green sheet for the insulating layer. When the wiring substrate 1B includes a side-surface metal layer of the side-surface metal body 9B as the side-surface metal body, the side-surface metal layer is formed by hole printing. The second frame-shaped metal layer 12 is formed by a thin film forming method such as a vapor deposition method, an ion plating method, or a sputtering method.

A nickel plating layer/gold plating layer as a metal plating layer may be deposited on externally exposed surfaces of the first wiring conductor 4, the second wiring conductor 5, the frame-shaped metal layer 6, the heat dissipation member 7, the side-surface metal layer 9, the metalized layer 10, and the second frame-shaped metal layer 12 by a plating method such as an electrolytic plating method or an electroless plating method. Consequently, corrosion of the first wiring conductor 4, the second wiring conductor 5, and the like can be effectively reduced.

The electronic device 200B has the following configuration, instead of including the lid 8 (refer to FIG. 4).

The electronic device 200B may include a flat plate-shaped lid 8B. The lid 8B may have a flat plate frame-shaped lid main body 81B bonded to the metal frame body 11. The lid main body 81B is made of, for example, metal having a small difference in thermal expansion coefficient from a ceramic such as an iron-nickel (Fe-Ni) alloy or an iron-nickel-cobalt (Fe-Ni-Co) alloy. The lid 8B may be bonded to the metal frame body 11 by brazing and soldering or welding, for example resistance welding such as seam welding.

When the electronic component 300 is an optical element, as in the example illustrated in FIG. 17, the lid 8B may include a flat plate frame-shaped lid main body 81B having an opening portion and a window member 82B that closes the opening portion of the lid main body 81B. Although the window member 82B closes the opening portion of the lid main body 81B from the inside in FIG. 17, the window member may close the opening portion from the outside. The window member 82B transmits light emitted or received by the optical element, and is made of a translucent material such as glass. The window member 82B may have a lens shape as in the example illustrated in FIG. 17, or may have a flat plate shape. When the electronic component 300 is a semiconductor element or the like other than an optical element, the lid main body 81B may be made of a metal or a ceramic and have a flat plate shape without an opening portion. When the lid main body 81B is made of a ceramic, a metal film for bonding may be provided on the ceramic and bonded to the metal frame body 11 by brazing and soldering, or the lid main body may be bonded with a bonding material such as resin or glass without providing a metal film. When a bonding material such as resin or glass is used, the wiring substrate 1B need not include the metalized layer 10 and the metal frame body 11.

According to the configuration of the wiring substrate 1B of the third embodiment, as described above, the frame-shaped metal layer 6 has the plurality of projecting portions 61B protruding toward the heat dissipation member 7 side, and the plurality of projecting portions 61B are located so as to overlap the heat dissipation member 7 in a transparent plan view. For this reason, when a space for holding the brazing material B is formed between the heat dissipation member 7 and the frame-shaped metal layer 6 and the heat dissipation member 7 is brazed to the frame-shaped metal layer 6, outflow of the brazing material B to the component mounting surface 7a side of the heat dissipation member 7 can be reduced. The projecting portion 61 of the frame-shaped metal layer 6 can support the heat dissipation member 7, and when brazing the heat dissipation member 7 to the frame-shaped metal layer 6, the amount of the brazing material B pushed out toward the component mounting surface 7a side of the heat dissipation member 7 by the weight of the heat dissipation member 7 can be reduced.

Therefore, according to the wiring substrate 1B of the third embodiment, the brazing material B is not located on the component mounting surface 7a of the heat dissipation member 7, or the amount of the brazing material B located on the component mounting surface 7a of the heat dissipation member 7 can be reduced. Therefore, according to the wiring substrate 1B of the third embodiment, the flatness of the component mounting surface 7a of the heat dissipation member 7 can be improved. Consequently, the connection reliability between the wiring substrate 1B and the electronic component 300 can be enhanced, and at the same time, the heat dissipation property can be improved.

In the case where the plurality of projecting portions 61B of the frame-shaped metal layer 6 are located at intervals in the circumferential direction of the frame-shaped metal layer 6, the space for holding the brazing material B between the heat dissipation member 7 and the frame-shaped metal layer 6 is larger than in the case where the projecting portion 61 is annular. Consequently, when brazing the heat dissipation member 7 to the frame-shaped metal layer 6, the outflow of the brazing material B toward the component mounting surface 7a side of the heat dissipation member 7 can be further reduced. In particular, when the brazing material B is clad, a flow path of the brazing material B can be formed between the projecting portions 61B adjacent to each other in the circumferential direction, and when brazing the heat dissipation member 7 to the frame-shaped metal layer 6, the brazing material B is likely to flow out from a central portion (component mounting surface 7a) of the heat dissipation member to the outer edge side of the frame-shaped metal layer 6 through the flow path. Therefore, according to the wiring substrate 1B of the third embodiment, the flatness of the component mounting surface 7a of the heat dissipation member 7 can be further improved, as in the wiring substrate 1A of the second embodiment.

Since the brazing material B can be caused to flow out from the central portion of the heat dissipation member 7 to the outside even when the part inside the projecting portion 61B of the frame-shaped metal layer 6 (part outside the through hole 22 of the heat dissipation member 7) is not made large, the size of the wiring substrate 1B is not increased.

When the plurality of projecting portions 61B of the frame-shaped metal layer 6 are located at intervals in the circumferential direction of the frame-shaped metal layer 6, the holding amount of the brazing material B between the heat dissipation member 7 and the frame-shaped metal layer 6 can be increased. Consequently, according to the wiring substrate 1B of the third embodiment, the bonding strength between the heat dissipation member 7 and the frame-shaped metal layer 6 is enhanced, and the stress of the insulating substrate 2 caused due to the difference in thermal expansion between the heat dissipation member 7 and the insulating substrate 2 is relaxed.

When the plurality of side-surface metal bodies 9B are located on the inner peripheral surface of the recessed portion 21 of the insulating substrate 2, the brazing material B wets and spreads to the side-surface metal bodies 9B connected to the frame-shaped metal layer 6. Consequently, when brazing the heat dissipation member 7 to the frame-shaped metal layer 6, the outflow of the brazing material B toward the component mounting surface 7a side of the heat dissipation member 7 can be further reduced. Therefore, according to the wiring substrate 1B of the third embodiment, the flatness of the component mounting surface 7a of the heat dissipation member 7 can be further improved.

When the side-surface metal body 9B is located on the inner peripheral surface of the recessed portion 21 of the insulating substrate 2, the holding amount of the brazing material B can be increased even if the layer width of the frame-shaped metal layer 6 is reduced. Consequently, according to the wiring substrate 1B of the third embodiment, the size of the recessed portion 21 of the insulating substrate 2 can be reduced, thereby reducing the size of the wiring substrate 1B, in other words, the size of the electronic device 200B.

When the plurality of side-surface metal bodies 9B are located at intervals in the circumferential direction of the inner peripheral surface of the recessed portion 21 of the insulating substrate 2, regions without the brazing material B are present at intervals in the circumferential direction between the outer peripheral surface of the heat dissipation member 7 and the inner peripheral surface of the recessed portion 21 of the insulating substrate 2. Consequently, the stress of the insulating substrate 2 caused due to the difference in thermal expansion between the heat dissipation member 7 and the insulating substrate 2 is relaxed, and the heat dissipation property from the brazing material B around the heat dissipation member 7 is improved.

In the case where the side-surface metal layer 9 extends to the opening end of the recessed portion 21 of the insulating substrate 2, as illustrated in FIGs. 22 and 23, when solder-mounting the wiring substrate 1B onto the mother substrate 400, the solder S creeps up the side-surface metal body 9B to form a solder fillet Sf extending from the side-surface metal body 9B toward a center side of the recessed portion 21 of the insulating substrate 2. Consequently, the solder S comes into contact with the heat dissipation member 7, and the heat dissipation member 7 is easily bonded to the connection pad 430 of the mother substrate 400.

FIGs. 22 and 23 illustrate a case where a space V is present between the outer peripheral surface of the heat dissipation member 7 and the side-surface metal body 9B on the opening side of the recessed portion 21 of the insulating substrate 2. When solder-mounting the wiring substrate 1B onto the mother substrate 400, the solder S creeps up the side-surface metal body 9B and the solder fillet Sf is easily formed. Consequently, the solder S comes into contact with the heat dissipation member 7, and the heat dissipation member 7 is more easily bonded to the connection pad 430 of the mother substrate 400. In order to achieve more reliable bonding by the solder fillet Sf, a width of the space V (a distance between the outer peripheral surface of the heat dissipation member 7 and the side-surface metal body 9B) may be set to be equal to or less than the thickness of the heat dissipation member 7.

In the case where the second frame-shaped metal layer 12 is located on the second surface 2b of the insulating substrate 2, as illustrated in FIGs. 21 and 22, when solder-mounting the wiring substrate 1B onto the mother substrate 400, the solder S is likely to creep up the side-surface metal body 9B, and a solder fillet Sf is easily formed. Consequently, the solder S comes into contact with the heat dissipation member 7, and the heat dissipation member 7 is more easily bonded to the connection pad 430 of the mother substrate 400.

Specifically, the second frame-shaped metal layer 12 is located on the second surface 2b of the insulating substrate 2, as in the external electrodes 42, 52, and is located at the same height position. For this reason, when the external electrode 42,52 comes into contact with the solder S, the second frame-shaped metal layer 12 also comes into contact with the solder S. Since the second frame-shaped metal layer 12 is connected to the side-surface metal body 9B, the solder S wets and spreads from the second frame-shaped metal layer 12 to the side-surface metal body 9B, and the solder fillet Sf is more reliably formed.

The outer edge of the connection pad 430 may be located outside the outer edge of the second frame-shaped metal layer 12. An amount of the solder S for forming the solder fillet Sf is increased by a difference in size between the connection pad 430 and the second frame-shaped metal layer 12. As a result, the solder S creeps up the side-surface metal body 9B, and the solder fillet Sf is easily formed. In other words, a larger solder fillet Sf that is more easily connected to the heat dissipation member 7 is more easily formed.

### Other Embodiments

Although not illustrated in the drawings, the inner peripheral surface of the recessed portion 21 of the insulating substrate 2 may be inclined with respect to the thickness direction of the insulating substrate 2 so as to become gradually separated from the outer peripheral surface of the heat dissipation member 7 toward the opening end side of the recessed portion 21. In this case, a plating solution easily enters the recessed portion 21 of the insulating substrate 2, and an occurrence of plating defects such as plating chipping can be reduced.

The heat dissipation member 7 may have, on its outer peripheral surface, a plurality of projections that come into contact with the inner peripheral surface of the recessed portion 21 of the insulating substrate 2. Alternatively, the insulating substrate 2 may have, on the inner peripheral surface of the recessed portion 21, a projecting portion that comes into contact with the outer peripheral surface of the heat dissipation member 7. In this case, it is easy to position the heat dissipation member 7 in the recessed portion 21 of the insulating substrate 2.

The interval between the inner peripheral surface of the recessed portion 21 of the insulating substrate 2 and the outer peripheral surface of the heat dissipation member 7 need not be constant in the circumferential direction, and an area where the interval between the inner peripheral surface of the recessed portion 21 of the insulating substrate 2 and the outer peripheral surface of the heat dissipation member 7 is wide may be locally provided. The area where the interval between the inner peripheral surface of the recessed portion 21 of the insulating substrate 2 and the outer peripheral surface of the heat dissipation member 7 is wide may be locally formed by making the shape of the heat dissipation member 7 in a circular shape in a bottom view. In this case, when the plating solution enters the wide area, the plating solution easily enters the entire circumference of the outer peripheral surface of the heat dissipation member 7 due to capillary action.

Other electronic components such as a diode, a coil, and a capacitor may be mounted on the first surface 2a of the insulating substrate 2. The other electronic components include an electronic component for controlling the electronic component 300.

In the present disclosure, the invention has been described above based on the various drawings and examples. However, the invention according to the present disclosure is not limited to the above-described embodiments. That is, the embodiments of the invention according to the present disclosure can be modified in various ways within the scope illustrated in the present disclosure, and embodiments obtained by appropriately combining the technical means disclosed in different embodiments are also included in the technical scope of the invention according to the present disclosure. In other words, a person skilled in the art can easily make various variations or modifications based on the present disclosure. Note that these variations or modifications are included within the scope of the present disclosure.

### REFERENCE SIGNS

1 Wiring substrate (wiring substrate according to first embodiment)
2 Insulating substrate
2a First surface
2b Second surface
21 Recessed portion of insulating substrate
22 Through hole of insulating substrate
3 Insulating frame body
31 Through hole of insulating frame body
32 Step portion of through hole of insulating frame body
4 First wiring conductor
41 First electrode
42 First external electrode
43 First connection wiring
5 Second wiring conductor
51 Second electrode
52 Second external electrode
53 Second connection wiring
6 Frame-shaped metal layer (frame-shaped metal portion)
61 Projecting portion
7 Heat dissipation member
7a Component mounting surface
8 Lid
200 Electronic Device (electronic device according to first embodiment)
300 Electronic component
400 Mother substrate
410 First electrode of mother substrate
420 Second electrode of mother substrate
430 Connection pad of mother substrate
B Brazing material
S Solder
V Space
W Bonding wire
1A Wiring substrate (wiring substrate according to second embodiment)
44 First connection wiring layer
54 Second connection wiring layer
61A Projecting portion
8A Lid
81A Lid main body
82A Step portion
83A Window member
9 Side-surface metal layer (side-surface metal portion)
10 Metalized layer
11 Metal frame body
200A Electronic device (electronic device according to second embodiment)
Sf Solder fillet
1B Wiring substrate (wiring substrate according to third embodiment)
23 Groove
61B Projecting portion
8B Lid
81B Lid main body
82B Window member
9B Side-surface metal body (side-surface metal portion)
12 Second frame-shaped metal layer (second frame-shaped metal body)
200B Electronic device (electronic device according to third embodiment)

## Claims

1. A wiring substrate comprising:
an insulating substrate having a first surface, a second surface located on an opposite side to the first surface, a recessed portion opening to the second surface, and a through hole penetrating from a bottom surface of the recessed portion to the first surface;
a wiring conductor extending from the first surface to the second surface;
a frame-shaped metal portion located on the bottom surface of the recessed portion and surrounding the through hole; and
a heat dissipation member located in the recessed portion and closing the through hole, bonded to the frame-shaped metal portion by a brazing material, and having a component mounting surface on the through hole side, wherein
the frame-shaped metal portion comprises a projection portion protruding toward the heat dissipation member, and the projection portion is located so as to overlap the heat dissipation member in a transparent plan view.

2. The wiring substrate according to claim 1, wherein
the projecting portion has an annular shape surrounding the through hole.

3. The wiring substrate according to claim 1, wherein
the projecting portion is provided in a plurality, and the plurality of projecting portions are located at intervals in a circumferential direction of the frame-shaped metal portion.

4. The wiring substrate according to any one of claims 1 to 3, further comprising:
a side-surface metal portion located on an inner peripheral surface of the recessed portion, connected to the frame-shaped metal portion, and extending from the bottom surface side toward an opening side of the recessed portion.

5. The wiring substrate according to claim 4, wherein
the side-surface metal portion has an annular shape located over an entire circumference of an inner peripheral surface of the recessed portion.

6. The wiring substrate according to claim 4, wherein
the side-surface metal portion is provided in a plurality, and the plurality of side-surface metal portions are located at intervals in a circumferential direction of the inner peripheral surface of the recessed portion.

7. The wiring substrate according to claim 6, wherein
the side-surface metal portion is provided in a plurality, and the side-surface metal portions are located in a plurality of grooves provided at intervals in the circumferential direction on the inner peripheral surface of the recessed portion.

8. The wiring substrate according to any one of claims 4 to 7, wherein
the side-surface metal portion extends to an opening end of the recessed portion.

9. The wiring substrate according to claim 8, further comprising:
a second frame-shaped metal portion located on the second surface, connected to the side-surface metal portion, and surrounding an opening of the recessed portion.

10. The wiring substrate according to any one of claims 4 to 9, wherein
a space is present between an outer peripheral surface of the heat dissipation member and the side-surface metal portion on the opening side of the recessed portion.

11. An electronic device comprising:
the wiring substrate according to any one of claims 1 to 10; and
an electronic component mounted on the component mounting surface of the heat dissipation member, located in the through hole, and electrically connected to the wiring conductor.
